(19) Europäisches Patentamt
European Patent Office
Office européen des brevets

(11) Publication number: **0 107 897**
**B1**

# (12) EUROPEAN PATENT SPECIFICATION

(45) Date of publication of patent specification: **01.04.87**

(51) Int. Cl.[4]: **C 08 G 73/12,** B 32 B 15/08

(21) Application number: **83305250.9**

(22) Date of filing: **08.09.83**

(54) **Polyamino-bis-imide resin.**

(30) Priority: **08.09.82 JP 156046/82**

(43) Date of publication of application:
**09.05.84 Bulletin 84/19**

(45) Publication of the grant of the patent:
**01.04.87 Bulletin 87/14**

(84) Designated Contracting States:
**DE FR GB**

(56) References cited:
**EP-A-0 047 530**

(73) Proprietor: **Hitachi Chemical Co., Ltd.**
**1-1, Nishi-shinjuku 2-chome Shinjuku-ku**
**Tokyo 160 (JP)**

(72) Inventor: **Fujioka, Atsushi**
**234-106, Oaza-Ozakata**
**Shimodate-shi Ibaragi-ken (JP)**
Inventor: **Miyadera, Yasuo**
**232-16, Oaza-Ozakata**
**Shimodate-shi Ibaragi-ken (JP)**
Inventor: **Fukuda, Tomio**
**1388, Higuchi**
**Shimodate-shi Ibaragi-ken (JP)**

(74) Representative: **Sheard, Andrew Gregory et al**
**Kilburn & Strode 30, John Street**
**London WC1N 2DD (GB)**

**EP 0 107 897 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

This invention relates to a polyamino-bis-imide resin, solutions thereof, cross-linked resins derived from them and laminated boards made from them. More particularly, this invention relates to a polyamino-bis-imide resin which dissolves in ordinary organic solvents of low boiling points and, on curing, acquires outstanding thermal resistance as well as to solutions thereof, cross-linked resins derived therefrom and laminated boards made therefrom.

Heretofore, polyamino-bis-maleimide resins such as, for example, a polyimide resin formed of N,N'-4,4'-diphenylmethane-bis-maleimide and 4,4'-diaminodiphenyl-methane have found acceptance in the production of heat resistant adhesives and heat resistant laminates which are required to exhibit superior thermal resistance, dimensional stability and electrical properties (U.S. Re. Patent No. 29,316). These polyamino-bis-maleimide resins, however, have the disadvantage that they are soluble only in special high-boiling point solvents such as, for example, expensive N-methyl-2-pyrrolidone (boiling point 202°C) and N,N-dimethylformamide (boiling point 153°C). The use of such special high-boiling point solvents has proved undesirable because the solvents adversely affect the work environment and also because high concentrations of them remain in a shaped article formed of the resin. When such a special high-boiling point solvent is used in the production of heat resistant laminated board, especially in the course of application of a prepared resin solution, various problems may arise. Varnish can exude from the prepreg and the solvent may persist in the laminated board, with possibly adverse effects on how the board absorbs boiling water and its resistance to measling.

As a solution of this problem, there has been proposed an imide type of prepolymer produced by the reaction of an epoxy resin soluble in ordinary low-boiling point organic solvents with a bisimide and a diamine (U.S. Patent No. 4,346,206). This imide type prepolymer, however, has the disadvantage that it exhibits a lower glass transition point than a polyamino-bis-imide resin formed of a bisimide and a diamine because it incorporates the epoxy compound.

This invention enables the provision of a novel polyamino-bis-imide resin and cross-linked resins derived therefrom.

This invention also enables the provision of a polyamino-bis-imide resin which dissolves in ordinary low-boiling point organic solvents and, on curing, acquires outstanding thermal resistance and to cross-linked resins derived from such a resin.

EP—A—0047530 discloses a maleimide resin produced by reacting a maleimide compound having the general formula:

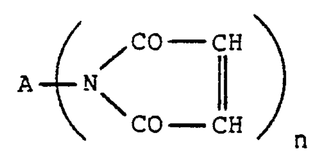

with a diamine having the general formula:

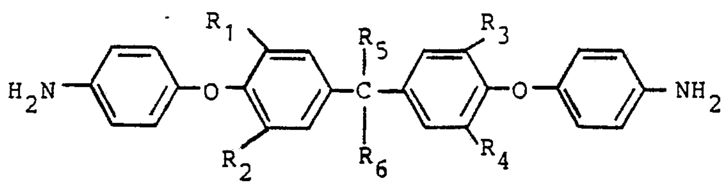

wherein:

A represents a mono-, di-, tri- or tetravalent organic group containing at least two carbon atoms;

n represents an integer of 1 to 4;

$R_1$ to $R_4$, which may be the same or different, represent hydrogen atom, a lower alkyl group, a lower alkoxy group, a chlorine atom or a bromine atom; and

$R_5$ and $R_6$, which may be the same or different, represent a hydrogen atom, a methyl group, an ethyl group, a trifluoromethyl group or a trichloromethyl group.

The present invention provides in a first aspect a curable polyamino-bis-imide resin obtainable by the thermal reaction of (A) a bis-imide represented by the general formula I:

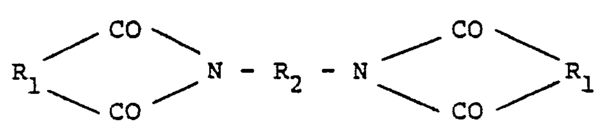

(I)

wherein $R_1$ stands for a divalent organic group having a carbon-carbon double bond and $R_2$ for a divalent aromatic organic group having 1 to 3 benzene rings with (B) a diamine represented by the general formula IIA:

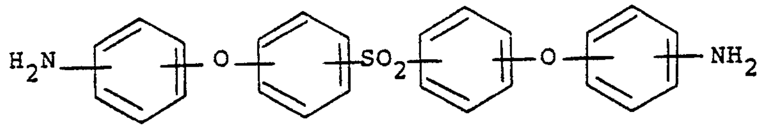 (IIA),

the mol ratio of the bis-imide (A) to the diamine (B) being in the range of 1:0.1 to 1:1. In a second aspect, the invention provides a solution of the aforementioned curable polyamino-bis-imide resin in a low-boiling point organic solvent.

In a third aspect, the invention provides a cross-linked resin obtained by curing the aforementioned curable polyamino-bis-imide resin.

In a fourth aspect, the invention provides a copper clad laminated board obtained by bonding a copper foil to a fibre-reinforced polyamino-bis-imide resin obtainable by the thermal reaction of (A) a bis-imide represented by the general formula I:

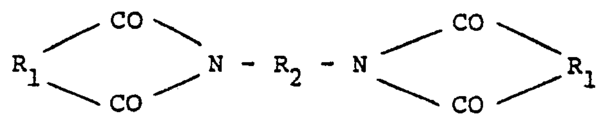 (I)

wherein $R_1$ stands for a divalent organic group having a carbon-carbon double bond and $R_2$ for a divalent aromatic organic group having 1 to 3 benzene rings with (B) a diamine represented by the general formula II:

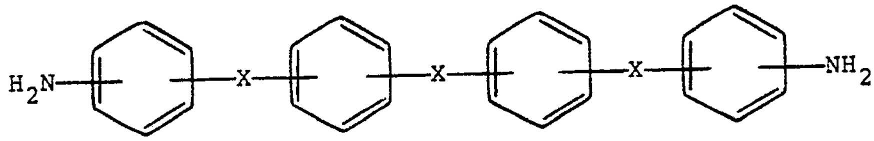 (II)

wherein X stands for one member selected from O, S, $SO_2$, $CH_2$, CO, COO, $C(CH_3)_2$, $CF_2$ and $C(CF_3)_2$, providing that the three X's may be identical to or different from one another and one or more of the hydrogen atoms attached to the benzene rings may be substituted by an inactive alkyl group, perfluoroalkyl group or halogen atom.

The accompanying drawing shows a cross section illustrating a typical and exemplary laminated board obtained in accordance with the present invention.

The reaction of the bis-imide (A) with the diamine (B) is understood to proceed with addition of the $-NH_2$ group of the diamine (B) to the carbon-carbon double bond of the bis-imide (A) and the consequent formation of a

$$-CRH-\overset{|}{C}R-NH-$$

linkage (wherein R stands for a substituent on the relevant carbon atom) and, thus, to produce a linearly polymerized polyamino-bis-imide resin. The polyamino-bis-imide resin which is produced by this method has been found to be soluble in any ordinary low-boiling point organic solvent and the resin dissolved in this solvent, on curing, has been found to acquire outstanding thermal properties.

The bis-imides (A) which are usable for the purpose of this invention are represented by the aforementioned general formula I. In this general formula, $R_1$ stands for a divalent organic group having a carbon-carbon double bond. Typical examples of this divalent organic group are alkylenes including cyclo-alkenylenes (which include bicycloalkenylenes), such as

$-CH=CH-$, 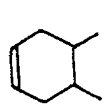 , 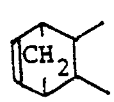

and derivatives resulting from the substitution of hydrogen atoms in these organic groups by an alkyl group or a halogen atom. $R_2$ stands for a divalent aromatic organic group having 1 to 3 benzene rings. This divalent aromatic organic group may be

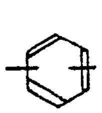, 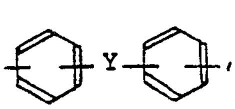, or 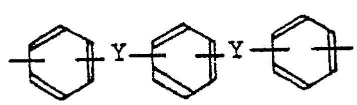

wherein Y stands for one member selected from O, S, $SO_2$, $CH_2$, CO, COO, $C(CH_3)_2$, $CF_2$ and $C(CF_3)_2$, providing that the two Y's may be identical to or different from each other and the hydrogen atoms

attached to the benzene rings may be substituted by an inactive group or atom for example, an alkyl group, a perfluoroalkyl group or a halogen atom.

Examples of unsaturated bis-imides are N,N'-m-phenylene-bis-maleimide, N,N'-p-phenylene-bis-maleimide, N,N'-4,4'-diphenylether-bis-maleimide, N,N'-4,4'-diphenylthioether-bis-maleimide, N,N'-4,4'-diphenylsulphon-bis-maleimide, N,N'-4,4-diphenylmethane-bis-maleimide, N,N'-4,4'-diphenylpropane-bis-maleimide, N,N'-[4,4'-diphenoxy-1,4-benzene]-bis-maleimide, N,N'-4,4'-diphenylmethane-bis-tetrahydrophthalimide and N,N'-4,4-didiphenylpropane-bis-endomethylenetetrahydrophthalimide.

The diamines (B) which are usable for the purpose of the fourth aspect of this invention are represented by the general formula II. Examples of these diamines are 4,4'-di-(p-aminophenoxy)-diphenyl sulphone, 4,4'-di-(m-aminophenoxy)-diphenyl sulphone, 4,4'-di-(p-aminophenoxy)-diphenyl ether, 4,4'-di-(m-aminophenoxy)-diphenyl ether, 4,4-di-(p-aminophenoxy)-diphenylmethane, 4,4'-di-(m-aminophenoxy)-diphenylmethane, 4,4'-di-(p-aminophenoxy)-diphenylpropane, 4,4'-di-(m-aminophenoxy)-diphenylpropane, 4,4'-di-(p-aminophenylsulphonyl)-diphenyl ether, 4,4'-di-(m-aminophenylsulphonyl)-diphenyl ether, 4,4'-di-(p-aminophenylthioether)-diphenylsulphide, 4,4'-di-(m-aminophenylthioether)-diphenylsulphide, 4,4'-di-(p-aminobenzoyl)-diphenyl ether, 4,4'-di-(p-aminophenoxy)-diphenyldifluoromethane and 4,4'-di-(p-aminophenoxy)-diphenyl hexafluoropropane. Two or more of these diamines may be used together without detrimental effect. Any of the diamines (B) mentioned above may be used in combination with any known diamine having one to three benzene rings without detrimental effect.

As a counterpart of the present invention, Japanese Unexamined Patent Application Disclosure SHO 57(1982)—40462 discloses a combination of N,N'-4,4'-di-(p-aminophenoxy)-diphenylpropane-bis-endomethylene-tetrahydrophthlimide (a bis-imide having four benzene rings in the portion corresponding to $R_2$) with N,N'-4,4'-di-(p-aminophenoxy)-diphenyl propane. Because of the large number of benzene rings, however, the combination has a low glass transition point and has serious economic disadvantages.

The molar mixing ratio of a bis-imide (A) to a diamine (B) is in the first to third aspects of the invention in the range of from 1:0.1 to 1:1, preferably from 1:0.25 to 1:0.8. In the fourth aspect, these ranges constitute preferred embodiments. If the amount of the diamine (B) to be mixed with 1 mole of the bis-imide (A) is less than 0.1 mole, the solubility of the resulting resin may be insufficient. If the amount of the diamine (B) to be mixed with 1 mole of the bis-imide (A) exceeds 1 mole, the molecule may lack the double bond at its terminal and, therefore, be incapable of crosslinking. The temperature of the reaction of the bis-imide (A) with the diamine (B) is preferably in the range of 100° to 200°C, preferably 120° to 150°C. If the temperature is below 100°C, then the reaction may not proceed smoothly. If the temperature exceeds 200°C, there is a possibility of gelation being induced. The duration of the reaction of the bis-imide (A) with the diamine (B) varies with the reactivity of the particular reactants involved in the reaction. But if the reaction time is too short, then a large portion of the bis-imide (A) remains unreacted and the resultant resin, in consequence, exhibits insufficient solubility. If the reaction time is too long, the polymerization proceeds too far and the resin tends to be insufficiently soluble. The duration of this reaction is generally in the range of 5 to 480 minutes, preferably 10 to 120 minutes.

The reaction of the bis-imide (A) with the diamine (B) can be carried out in the absence of a solvent when the reactants are heated at a temperature exceeding the melting point of either of the two reactants. It may be carried out thermally in an organic solvent whose boiling point (at 760 mmHg) is in the range of 100° to 170°C, preferably 120° to 150°C. Examples of the organic solvents satisfying this condition are 2-methoxyethanol and 2-ethoxyethanol, 2-(methoxymethoxy)-ethanol and 2-isopropoxy-ethanol. When the reaction is carried out in any of the organic solvents enumerated above, the polyamino-bis-imide resin produced may be precipitated by adding, in a large excess, a poor solvent for the polyamino-bis-imide resin such as, for example, water or methanol. Then, the polyamino-bis-imide resin can be obtained in a solid state by separating the precipitate by filtration and drying the separated precipitate. Also the reaction mixture may be used as a solution without precipitating the solid resin.

A polyamino-bis-imide resin of this invention which is produced as described above readily dissolves at room temperature in a low boiling point organic solvent such as, for example, methylethyl ketone (boiling point 80°C) 2-methoxyethanol (boiling point 124°C) or ethoxyethanol (135°). The polyamino-bis-imide resin, therefore, can be used conventionally in the form of a solution obtained by dissolving the resin in a concentration of 20 to 70% by weight, preferably 40 to 60% by weight, in an organic solvent having a boiling point in the range of 70° to 160°C, preferably 80° to 140°C, for the production of laminated boards, for example. The conventional polyamino-bis-imide resin dissolves only in such special and expensive high-boiling point solvents as N-methyl-2-pyrrolidone (boiling point 202°C). The solvent contained in the resin as produced cannot sufficiently be removed from the resin during a solvent removal treatment involving the application of heat. By contrast, since the polyamino-bis-imide resin of the present invention can be dissolved in an inexpensive ordinary low boiling point solvent, the removal of the solvent in the resin by the application of heat can easily be accomplished. Thus, far less solvent persists in a shaped article formed of the resin.

A curable polyamino-bis-imide resin obtained in accordance with this invention can be converted into a thermally stable cross-linked resin by being thermoset at a temperature of 170° to 300°C, preferably 180° to 220°C, for a period of 0.5 to 48 hours, preferably 1 to 4 hours. In this thermosetting reaction, a radical reaction initiator may be used as a catalyst. Examples of radical reaction initiators usable advantageously in this reaction are organic peroxide such as tert-butyl peroxypropylcarbonate, dicumyl peroxide, tert-butyl

peroxyacetate, tert-butyl peroxybenzoate and di-tert-butyl peroxide and tert-butyl cumyl peroxide.

Such reinforcing fibres as glass-fibres and carbon fibres and such fillers as fused silica and calcium carbonate, for example, can be incorporated into a polyamino-bis-imide in accordance with the invention, or into a solution of such a resin in an organic solvent.

Curable polyamino-bis-imide resin in accordance with the invention can be moulded in any desired shape such as a board by, for example, compression moulding, transfer moulding or injection moulding. A copper clad laminated board 6 having a cross section as illustrated in the accompanying drawing is obtained by incorporating a reinforcing material for example, glass cloth into a resin of the invention and superposing a layer of the reinforced resin 4 between copper foils 2 and 2. This copper clad laminated board 6 is most useful as a substrate for various circuits.

The invention will now be described in detail with reference to the examples.

Example 1

The following synthesis was carried out by using an eggplant type flask provided with a condenser. In 196.6 parts by weight of 2-methoxyethanol 100 parts by weight of N,N'-4,4'-diphenylmethane-bis-maleimide

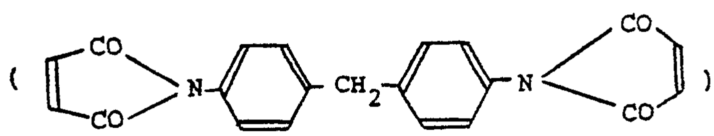

and 96.6 parts by weight of 4,4'-di-(p-aminophenoxy)-diphenyl sulphone

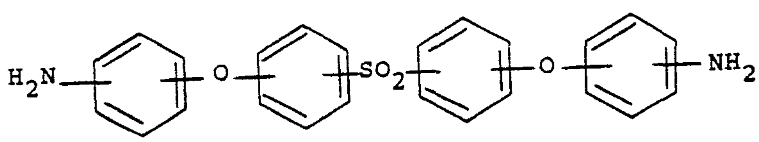

(1.0:0.8 molar ratio of bisimide to diamine) were stirred at an oil bath temperature of 120° to 130°C for 30 minutes to induce a thermal reaction and produce a polyamino-bis-imide resin. Then, the reaction solution was cooled to room temperature and the solution (concentration 50% by weight) was placed under observation for possible change in transparency due to occurrence of suspended matter. The solution, even at the end of seven days' standing, showed no sign of loss of transparency.

Example 2

A polyamino-bis-imide resin was synthesized by following the procedure of Example 1, except that 4,4'-di-(m-aminophenoxy)-diphenyl sulphone

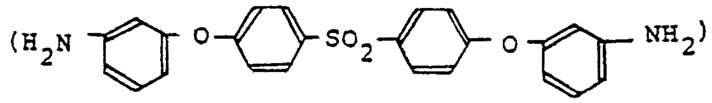

was used in the place of 4,4'-di-(p-aminophenoxy)-diphenyl sulphone. The solution resulting from the thermal reaction (concentration 50% by weight) was placed under observation for change in transparency due to occurrence of suspended matter. The solution, even at the end of seven days' standing, showed no sign of loss of transparency.

Preparations 1—4

A polyamino-bis-imide resin was synthesized by following the procedure of Example 1, except that 4,4'-di-(p-aminophenoxy)-diphenylpropane

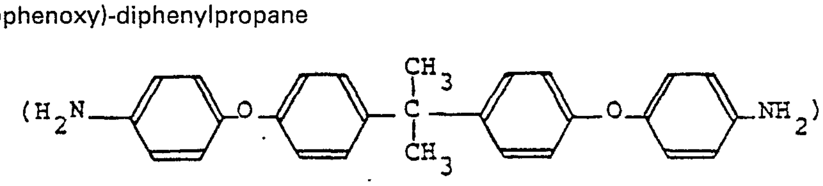

was used in a varying amount (parts by weight) indicated in Table 1 in the place of 4,4'-di-(p-amino-phenoxy)-diphenyl sulphone and 2-methoxyethanol was used in an amount such that the resultant solution had a concentration of 50% by weight. None of the solutions thus obtained showed any sign of loss of transparency due to occurrence of suspended matter even at the end of 7 days' standing.

To the solution of Preparation 1, methanol was added in a large excess to cause precipitation of polyamino-bis-imide resin in the solution. The precipitate was separated by filtration and dried under a vacuum to obtain a solid polyamino-bis-imide resin. This resin was tested for solubility in methylethyl

ketone. The resin was found to be soluble in this solvent at room temperature.

The solid polyamino-bis-imide resin was moulded in a metal die at 190°C for one hour under pressure (40 kg f/$cm^2$, 3.9 × $10^6$ N/$m^2$) and further subjected to post-curing at 250°C for 24 hours. The glass transition point (Tg) of the resultant cured resin was found from the point of curvature in the thermal expansion coefficient curve to be 302°C. It was thus shown to possess very high thermal resistance.

Controls 1—4

A polyamino-bis-imide resin was synthesized by following the procedure of Example 1, except that 4,4-diaminodiphenylmethane

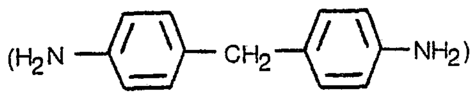

was used in the various amounts (parts by weight) indicated in Table 1 in the place of 4,4'-di-(p-aminophenoxy)-diphenyl sulphone and 2-methoxy-ethanol was used in an amount such that the resultant solution had a concentration of 50% by weight.

The solution of Control 1 became turbid after seven days' standing. The solutions of Controls 2—4 became turbid after one day's standing.

The polyamino-bis-imide resin of Control 1 was cured by following the procedure of Preparation 1 to yield a board of cured resin. This board was found by experiment to have a Tg of 325°C.

Preparation 5

Forty (40) parts by weight of 4,4'-di-(p-aminophenoxy)-diphenylpropane (melting point 119°C) was melted by heating at 150°C and then stirred with 100 parts by weight of N,N'-4,4'-diphenylmethane-bis-imide (1:0.35 molar ratio of bis-imide to diamine) at 150°C for 10 minutes to induce a thermal reaction in the absence of a solvent. The reaction product was cooled to room temperature. The polyamino-bis-imide resin thus obtained was tested for solubility in 2-methoxyethanol. The solution having a concentration of 50% by weight showed no sign of loss of transparency due to occurrance of suspended matter even at the end of seven days' standing.

TABLE 1

Solubility and thermal resistance of varying species of polyamino-bis-imide resin

| | Preparation 1 | Preparation 2 | Preparation 3 | Preparation 4 | Control 1 | Control 2 | Control 3 | Control 4 |
|---|---|---|---|---|---|---|---|---|
| Formulation | | | | | | | | |
| N,N'-4,4'-diphenylmethane-bis-maleimide | 100 | 100 | 100 | 100 | 100 | 100 | 100 | 100 |
| 4,4'-di-(p-aminophenoxy)-diphenylpropane | 40.2 | 57.2 | 74.4 | 91.6 | — | — | — | — |
| 4,4'-diaminodiphenylmethane | — | — | — | — | 19.2 | 27.6 | 36.0 | 44.4 |
| Bis-imide : diamine (molar ratio) | 1:0.35 | 1:0.5 | 1:0.65 | 1:0.8 | 1:0.35 | 1:0.5 | 1:0.65 | 1:0.8 |
| Solubility of resin in 2-methoxyethanol | ○ | ○ | ○ | ○ | Δ | × | × | × |
| Thermal resistance : Tg (°C) | 302 | — | — | — | 32.5 | — | — | — |

1) Denomination of numerical values given in Formulation: Parts by weight

2) Conditions for Tg test: Measured by thermo-mechanical analyser, TMA—1500, made by Shinkuriko Kabushiki Kaisha, with a temperature increase ratio of 5°C/min, under a load of 5 g.

3) Solubility: ○ Completely soluble, Δ Precipitated after 7 days, × Precipitated after 1 day.

Example 3

In 140 parts by weight of 2-methoxyethanol, 100 parts by weight of N,N'-4,4'-diphenylmethane-bis-maleimide and 40 parts by weight of 4,4'-di-(p-aminophenoxy)-diphenyl-propane (1.0:0.35 of molar ratio of bisimide to diamine) were stirred at 120°C to 130°C for 30 minutes to induce a thermal reaction and produced a polyamino-bis-imide resin solution (concentration 50% by weight). The polyamino-bis-imide resin solution was impregnated into a glass cloth having 0.2 mm of thickness (G—9020—BY52, manufactured by Nitto Boseki Kabushiki Kaisha), and dried at a temperature of 170°C for 3 minutes to obtain a prepreg. The prepreg thus obtained showed no varnish sagging.

Eight sheets of the prepreg were plied up, then two sheets of 35 µm thick copper foil (FC—TAI—35, manufactured by Furukawa Circuit Foil Kabushiki Kaisha) were plied up at both sides. These were then put between two mirror plates and pressed at a temperature of 200°C for two hours under a pressure of 40 kgf/$cm^2$ ($3.9 \times 10^6$ N/$m^2$) to obtain a 1.6 mm thick copper clad laminated board. Further, the copper plated laminated board was post cured at a temperature of 200°C for 5 hours.

The following properties of the copper clad laminated board (except last two properties) were tested using the methods of Japanese Industrial Standard (JIS) C—6481. The results are shown in Table 2.

TABLE 2

| | |
|---|---|
| Solder float (300°C, 5 minutes float) | no blistering<br>no delamination |
| Peel strength of copper foil | 1.6 kgf/cm (16 N/cm) |
| Insulation resistance (E−1/105) | $10^{13}$ Ω |
| Insulation resistance (E−1/105−1/105+D−2/100) | $10^{11}$ Ω |
| State after dipping into solder at 260°C for 30 seconds after treating in a pressure cooker at 121°C for 2 hours. | no blistering,<br>no delamination |
| Tg (used TMA—1500) | 180°C |

As described above, a polyamino-bis-imide resin produced according to the present invention is soluble in such inexpensive low-boiling point ordinary solvents as methylethyl ketone, 2 methoxyethanol, 2-ethoxyethanol and 2-isopropoxyethanol and the cured resin derived therefrom possesses outstanding thermal stability. Such resins are commercially valuable.

As described above, the copper clad laminated board had superior heat resistance properties and measling did not occur, even in a soldering test after severe moisture treating.

**Claims**

1. A curable polyamino-bis-amide resin characterised in that it is obtainable by the thermal reaction of:

(A) a bis-imide represented by the general formula I:

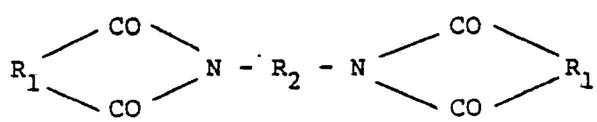

(I)

wherein $R_1$ stands for a divalent organic group having a carbon-carbon double bond and $R_2$ for a divalent aromatic organic group having 1 to 3 benzene rings, with

(B) a diamine represented by the general formula IIA:

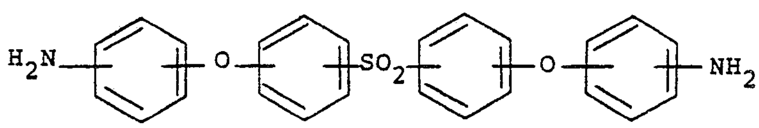

(IIA),

the mol ratio of the bis-imide (A) to the diamine (B) being in the range of 1:0.1 to 1:1.

2. A curable polyamino-bis-imide resin according to Claim 1, characterised in that the bis-imide (A) is N,N'-4,4'-diphenylmethane-bis-maleimide and/or the diamine (B) is at least one member selected from 4,4'-di-(aminophenoxy)-diphenyl sulphones.

3. A curable polyamino-bis-imide resin according to Claim 1 or 2, characterised in that the resin is obtained by carrying out the thermal reaction at a temperature in the range of from 100° to 200°C.

4. A curable polyamino-bis-imide resin according to any one of Claims 1 to 3, characterised in that the resin is obtained by carrying out the thermal reaction in an organic solvent selected from 2-methoxyethanol, 2-ethoxyethanol, 2-(methoxymethoxy)ethanol and 2-isopropoxyethanol.

5. A polyamino-bis-imide resin solution, obtained by dissolving a curable polyamino-bis-imide resin as claimed in any one of Claims 1 to 4 in an organic solvent having a boiling point in the range of from 70° to 160°C.

6. A polyamino-bis-imide resin solution according to Claim 5, wherein the organic solvent is at least one member selected from methylethyl ketone, 2-methoxyethanol and 2-ethoxyethanol.

7. A cross-linked resin characterised in that it is obtained by thermo setting a polyamino-bis-imide resin obtainable by the thermal reaction of:

(A) A bis-imide represented by the general formula I:

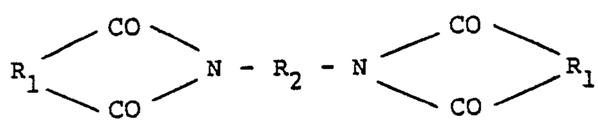
(I)

wherein $R_1$ stands for a divalent organic group having a carbon-carbon double bond and $R_2$ for a divalent aromatic organic group having 1 to 3 benzene rings, with

(B) a diamine represented by the general formula IIA:

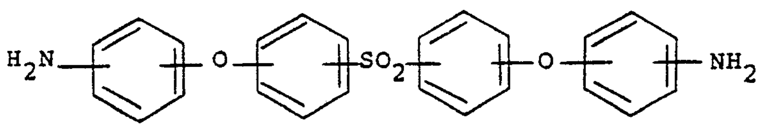
(IIA),

the mol ratio of the bis-imide (A) to be diamine (B) being in the range of 1:0.1 to 1:1.

8. A cross-linked resin according to Claim 7 characterised in that the thermosetting of the polyamino-bis-imide resin is carried out at a temperature in the range of from 170° to 300°C.

9. A copper clad laminated board comprising a fibre reinforced cross-linked polyamino-bis-imide resin obtainable by the thermal reaction of:

(A) a bis-imide represented by the general formula I:

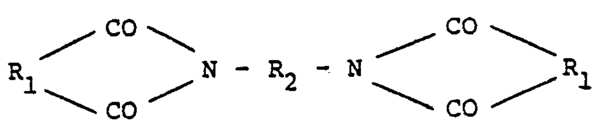
(I)

wherein $R_1$ stands for a divalent organic group having a carbon-carbon double bond and $R_2$ for a divalent aromatic organic group having 1 to 3 benzene rings, with

(B) a diamine represented by the general formula II:

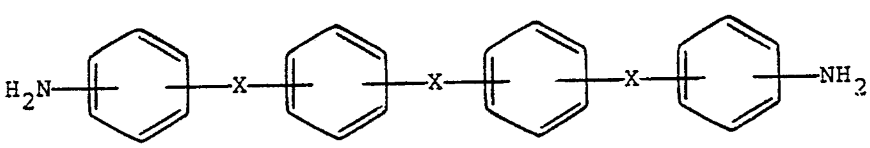
(II)

wherein X stands for one member selected from O, S, $SO_2$, $CH_2$, CO, COO, $C(CH_3)_2$, $CF_2$ and $C(CF_3)_2$, providing that the three X's may be identical to or different from one another and one or more of the hydrogen atoms attached to the benzene rings may be substituted by an inactive alkyl group, perfluoroalkyl group or halogen atom, the resin being bonded to a copper foil.

10. A copper clad laminated board comprising a fibre reinforced cross-linked polyamino-bis-imide resin as claimed in any one of Claims 1 to 8 bonded to a copper foil.

**Patentansprüche**

1. Härtbares Polyamino-bisimid-Harz, dadurch gekennzeichnet, daß es durch thermische Reaktion von (A) einem Bisimid der nachfolgenden allgemeinen Formel I

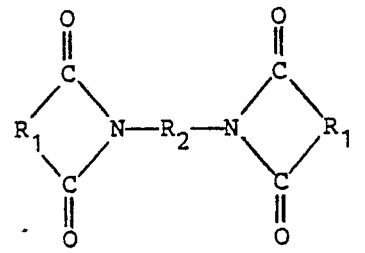

(I)

worin $R_1$ eine zweiwertige organische Gruppe mit einer Kohlenstoff-Kohlenstoff-Doppelbindung und $R_2$ eine zweiwertige aromatische organische Gruppe mit 1 bis 3 Benzolringen bedeutet, mit

(B) einem Diamin der nachfolgenden allgemeinen Formel IIA

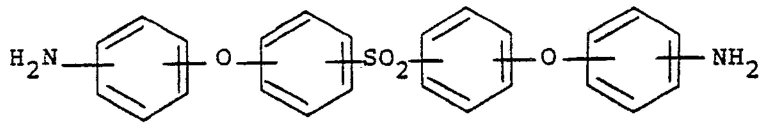

(IIA),

erhältlich ist, wobei das Molverhältnis des Bisimids (A) zu dem Diamin (B) im Bereich von 1:0,1 bis 1:1 liegt.

2. Härtbares Polyamino-bisimid-Harz nach Anspruch 1, dadurch gekennzeichnet, daß das Bisimid (A) N,N'-4,4'-Diphenylmethan-bismaleimid und/oder das Diamin (B) zumindest eine aus 4,4'-Di-(amino-phenoxy)-diphenylsulfonen ausgewählte Verbindung ist.

3. Härtbares Polyamino-bisimid-Harz nach einem der Ansprüche 1 bis 2, dadurch gekennzeichnet, daß das Harz durch thermische Reaktion bei einer Temperatur im Bereich von 100° bis 200°C erhalten wird.

4. Härtbares Polyamino-bisimid-Harz nach einem der Ansprüche 1 bis 3, dadurch gekennzeichnet, daß das Harz durch thermische Reaktion in einem organischen Lösungsmittel, ausgewählt aus 2-Methoxyäthanol, 2-Äthoxyäthanol, 2-(Methoxymethoxy)-äthanol und 2-Isopropoxyäthanol, erhalten wird.

5. Polyamino-bisimid-Harzlösung, dadurch gekennzeichnet, daß sie durch Auflösen eines härtbaren Polyamino-bisimid-Harzes nach einem der Ansprüche 1 bis 4 in einem organischen Lösungsmittel mit einem Siedepunkt im Bereich von 70° bis 160°C erhalten wird.

6. Polyamino-bisimid-Harzlösung nach Anspruch 5, dadurch gekennzeichnet, daß das organische Lösungsmittel zumindest eines ist, das aus Methyläthylketon, 2-Methoxyäthanol und 2-Äthoxyäthanol ausgewählt ist.

7. Vernetztes Harz, dadurch gekennzeichnet, daß es durch Hitzehärtung eines Polyamino-bisimid-Harzes erhalten wird, das durch thermische Reaktion von

(A) einem Bisimid der nachfolgenden allgemeinen Formel I

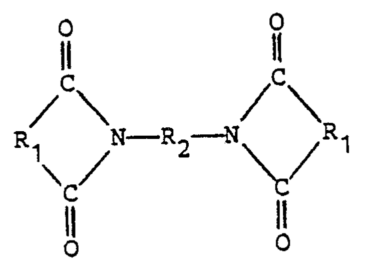

(I)

worin $R_1$ eine zweiwertige organische Gruppe mit einer Kohlenstoff-Kohlenstoff-Doppelbinding und $R_2$ eine zweiwertige aromatische organische Gruppe bis 1 bis 3 Benzolringen bedeutet, mit

(B) einem Diamin der nachfolgenden allgemeinen Formel IIA

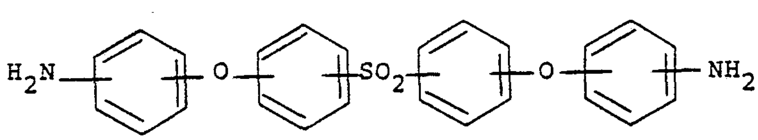

(IIA),

erhältlich ist, wobei das Molverhältnis des Bisimids (A) zu dem Diamin (B) im Bereich von 1:0,1 bis 1:1 liegt.

8. Vernetztes Harz nach Anspruch 7, dadurch gekennzeichnet, daß die Hitzehärtung des Polyamino-bisimid-Harzes bei einer Temperatur im Bereich von 170° bis 300°C durchgeführt wird.

9. Verkupferte laminierte Platte, dadurch gekennzeichnet, daß sie ein faserverstärktes vernetztes Polyamino-bisimid-Harz enthält, das durch thermische Reaktion von

(A) einem Bisimid der nachfolgenden allgemeinen Formel I

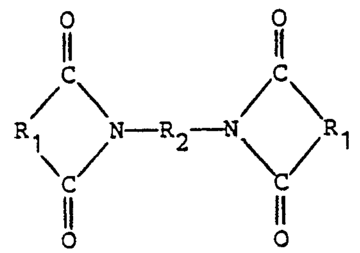

(I)

worin $R_1$ eine zweiwertige organische Gruppe mit einer Kohlenstoff-Kohlenstoff-Doppelbindung und $R_2$ eine zweiwertige aromatische organische Gruppe mit 1 bis 3 Benzolringen bedeutet, mit

(B) einem Diamin der nachfolgenden allgemeinen Formel II

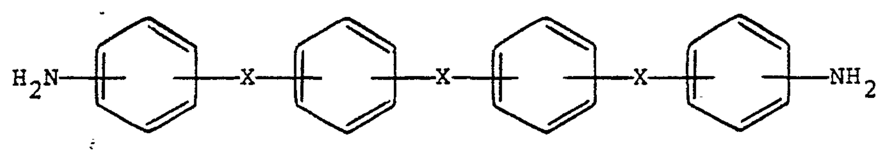

(II)

erhältlich ist, worin X einen Rest, ausgewählt aus O, S, $SO_2$, $CH_2$, CO, COO, $C(CH_3)_2$, $CF_2$ und $C(CF_3)_2$ bedeutet, vorausgesetzt, daß drei X-Reste identisch oder voneinander vorschieden sein können und ein oder mehrere mit den Benzolringen verbundene Wasserstoffatome durch eine inaktive Alkylgruppe, perfluoralkylgruppe oder ein Halogenatom ersetzt sein können, wobei das Harz an eine Kupferfolie gebunden ist.

10. Verkupferte laminierte Platte, dadurch gekennzeichnet, daß sie ein faserverstärktes, vernetztes Polyamino-bisimid-Harz nach einem der Ansprüche 1 bis 8, gebunden an eine Kupferfolie, enthält.

**Revendications**

1. Une résine de polyamino-bis-imide durcissable caractérisée en ce que l'on peut l'obtenir par une réaction à chaud de:

A) un bis-imide de formule générale I:

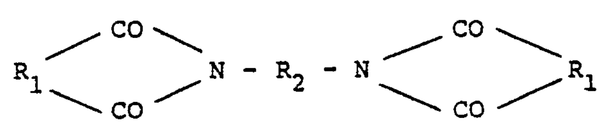

(I)

(dans laquelle $R_1$ représente un groupe organique divalent avec une double liaison carbone-carbone et $R_2$ un groupe organique aromatique divalent ayant de 1 à 3 cycles benzéniques) avec

B) une diamine de formule générale IIA:

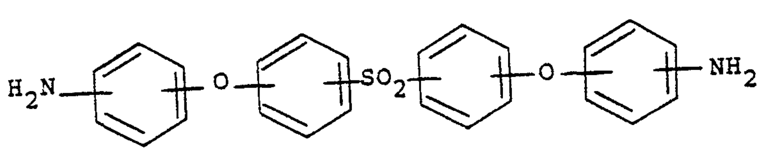

(IIA),

le rapport molaire du bis-imide A à la diamine B étant compris entre 1:0,1 et 1:1.

2. Une résine de polyamino-bis-imide durcissable selon la revendication 1 caractérisée en ce que le bis-imide (A) est le N,N'-4,4'-diphénylméthane-bis-maléimide et/ou la diamine (B) est une ou plusieurs 4,4'-di-(aminophénoxy)-diphénylsulfones.

3. Une résine de polyamino-bis-imide durcissable selon la revendication 1 ou 2 caractérisée en ce qu'on l'obtient en effectuant la réaction à une température comprise entre 100 et 200°C.

4. Une résine de polyamino-bis-imide durcissable selon l'une quelconque des revendications 1 à 3, caractérisée en ce qu'on l'obtient en effectuant la réaction dans un solvant organique choisi parmi le 2-méthoxyéthanol, le 2-éthoxyéthanol, le 2-(méthoxyméthoxy)-éthanol et le 2-isopropoxyéthanol.

5. Une solution d'une résine de polyamino-bis-imide obtenue par dissolution d'une résine de polyamino-bis-imide durcissable selon l'une quelconque des revendications 1 à 4 dans un solvant organique dont le point d'ébullition est compris entre 70 et 160°C.

6. Une solution de résine de polyamino-bis-imide selon la revendication 5 dont le solvant organique est la méthyléthylcétone, le 2-méthoxyéthanol ou le 2-éthoxyéthanol ou un mélange de plusieurs de ces solvants.

7. Une résine réticulée caractérisée en ce qu'elle est obtenue par durcissement à chaud d'une résine de polyamino-bis-imide pouvant être obtenue par réaction à chaud de:

A) un bis-imide de formule générale I:

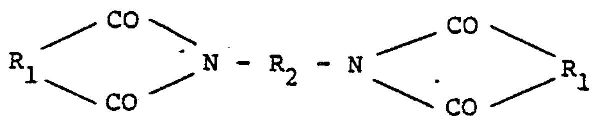

(I)

(dans laquelle $R_1$ représente un groupe organique divalent avec une double liaison carbone-carbone et $R_2$ un groupe organique aromatique divalent ayant de 1 à 3 cycles benzéniques) avec

B) une diamine de formule générale IIA:

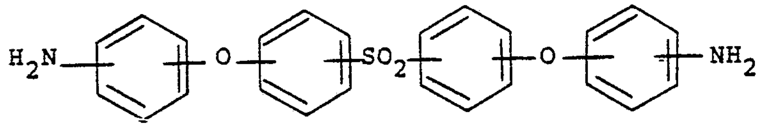

(IIA),

le rapport molaire du bis-imide A à diamine B étant compris entre 1:0,1 et 1:1.

8. Une résine réticulée suivant la revendication 7, caractérisée en ce que le durcissement à chaud a été effectuée à une température comprise entre 170 et 300°C.

9. Un panneau stratifié revêtu (plaqué) de cuivre, qui comprend une résine de polyamino-bis-imide réticulée renforcée de fibres, pouvant être obtenue par réaction à chaud de:

A) un bis-imide de formule générale I:

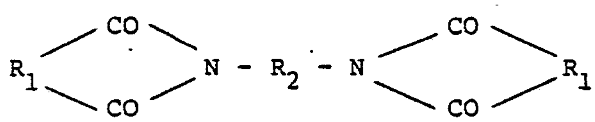

(I)

dans laquelle $R_1$ représente un groupe organique divalent avec une double liaison carbone-carbone et $R_2$ un groupe organique aromatique divalent ayant de 1 à 3 cycles benzéniques, avec

B) une diamine de formule générale II:

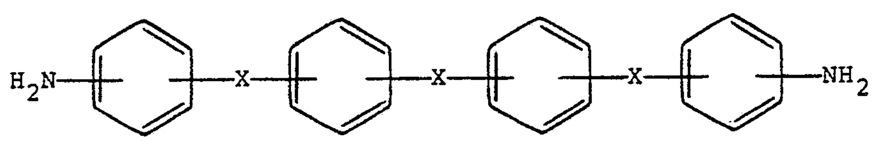

(II)

dans laquelle X représente O, S, $SO_2$, $CH_2$, COO $C(CH_3)_2$, $CF_2$ ou $C(CF_3)_2$, les trois X pouvant être identiques ou différents les uns des autres et un ou plusieurs des atomes d'hydrogène liés aux cycles benzéniques pouvant être remplacés par un groupe ou un atome inactifs, par exemple par un groupe alkyle ou perfluoroalkyle ou par un d'halogène, la résine étant liée à une feuille de cuivre.

10. Un panneau stratifié plaqué de cuivre comprenant une résine de polyamino-bis-imide réticulée et renforcée de fibres selon l'une quelconque des revendications 1 à 8, liée à une feuille de cuivre.

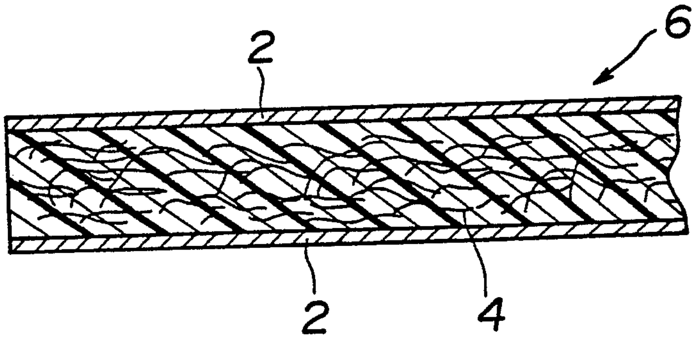

6
2
2
4